# EUROPÄISCHE PATENTSCHRIFT

(11) **EP 1 959 494 B1**
(45) Veröffentlichungstag und Bekanntmachung des Hinweises auf die Patenterteilung: **17.06.2009**
(21) Anmeldenummer: 08000987.1
(22) Anmeldetag: 19.01.2008
(51) Int. Cl.: H01L 25/07

(54) **Leistungshalbleitermodul**
Power semiconductor module
Module semi-conducteur de puissance

(30) Priorität: 14.02.2007 DE 102007007224
(43) Veröffentlichungstag der Anmeldung: 20.08.2008
(73) Patentinhaber: SEMIKRON Elektronik GmbH & Co. KG, 90431 Nürnberg (DE)
(72) Erfinder: Popp, Rainer, 91580 Petersaurach (DE); Lederer, Marco, 90453 Nürnberg (DE)

(56) Entgegenhaltungen:
- EP-A- 0 717 588
- DE-A1- 3 143 339
- DE-A1- 3 604 882
- DE-A1- 10 329 843
- DE-C1- 10 127 947
- DE-U1- 9 313 483

## Beschreibung

Die Erfindung betrifft ein Leistungshalbleitermodul mit einem Gehäuse, in welchem Lastanschlusselemente angeordnet sind, die Kontakteinrichtungen aufweisen, die in Gehäusemulden des Gehäuses angeordnetsind, die an einer zugehörigen Seitenwand des Gehäuses ausgebildet sind, und mit einem das Gehäuse bedeckenden Deckel.

Derartige Leistungshalbleitermodule sind in diversen Ausbildungen bekannt, wobei das Gehäuse mit mindestens einem elektrisch isolierenden Substrat kombiniert ist, das vorzugsweise zur Montage an einem Kühlbauteil vorgesehen ist. Das/jedes Substrat besteht aus einem Isolierstoffkörper mit einer Anzahl darauf befindlicher, gegeneinander elektrisch isolierter metallischer Leitungsbahnen und mit diesen schaltungsgerecht verbundenen Leistungshalbleiterbauelementen. Zusätzlich zu den Lastanschlusselementen weisen die Leistungshalbleitermodule Hilfsanschlusselemente auf, bei welchen es sich um Steuerungsanschlüsse für die Leistungshalbleiterbauelemente handelt.

Beispielsweise beschreibt die DE 42 37 632 A1 ein Leistungshalbleitermodul mit einer Druckeinrichtung, die ein stabiles, vorzugsweise metallisches Druckelement zum Druckaufbau, ein elastisches Kissenelement zur Druckspeicherung und ein Brückenelement zur Druckeinleitung auf besondere Bereiche der Substratoberfläche aufweist. Das Brückenelement ist vorzugsweise als Kunststoffformkörper mit einer vom Kissenelement abgewandten Fläche gestaltet, von der Druckfinger in Richtung der Substratoberfläche ausgehen.

Aus der DE 101 27 947 C1 ist ein Leistungshalbleitermodul bekannt, bei welchem die Lastanschlusselemente derartig ausgebildet sind, dass sie in Abschnitten eng benachbart senkrecht zur Substratoberfläche verlaufen und Kontaktfüße aufweisen, die den elektrischen Kontakt zu auf der Substratoberfläche vorgesehenen Leiterbahnen herstellen und gleichzeitig Druck auf das Substrat ausüben und somit dessen thermischen Kontakt zu einem Kühlbauteil herstellen.

Die DE 31 43 339 A1 beschreibt ein Leistungshalbleitermodul mit einem Gehäuse, in welchem Lastanschlusselemente angeordnet sind, die Kontakteinrichtungen aufweisen, die in Gehäusemulden des Gehäuses angeordnet sind, die an einer zugehörigen Seitenwand des Gehäuses ausgebildet sind. Weiterhin weist das Leistungshalbleitermodul einen Deckel auf, welcher durch Fixierstücke an Erhebungen des Gehäuses befestigt wird.

Die DE 93 13 483 U1 offenbart eine zur DE 31 43 339 A1 alternative Methode zur Montage des Deckels am Gehäuse, indem der Außenrand des Deckels in eine Vertiefungsnut im Gehäuse, womit eine hermetische Verbindung zwischen Gehäuse und Deckel hergestellt wurde.

Die EP 0 717 588 A2 offenbart ein Gehäuse für ein elektronisches Bauteil, welches aus zwei miteinander verbindbaren Gehäuseteilen besteht und einen als Rahmen ausgebildeten Träger für das im Gehäuse angeordnete elektrische Bauteil vorsieht. Weiterhin weist das Gehäuse zur Befestigung an einem Montageort Befestigungsanschlüsse auf.

Der Ereindung liegt die Aufgabe zugrunde, ein Leistungshalbleitermodul der eingangs genannten Art zu schaffen, das einfach ausgebildet und zuverlässig gegen das Eindringen von Flüssigkeit oder Feuchtigkeit geschützt ist.

Diese Aufgabe wird erfindungsgemäß durch die Merkmale des Anspruches 1, d.h. dadurch gelöst, dass das Gehäuse oberseitig materialeinstückig mit einem umlaufenden Dichtungsrahmen und der Deckel mit einem den umlaufenden Dichtungsrahmen übergreifenden Außenrand ausgebildet ist und auch dadurch, dass die jeweilige Gehäusemulde an ihrem Innenrand eine einen Abschnitt des Dichtungsrahmens bildende Dichtungsrippe aufweist, und dass das zugehörige Lastanschlusselement mit einer um die Dichtungsrippe herum gebogene Abkröpfung ausgebildet ist, an welche die Kontakteinrichtung des entsprechenden Lastanschlusselementes anschließt.

Durch die erfindungsgemäße Ausbildung des Leistungshalbleitermoduls ergibt sich der Vorteil, dass das Eindringen von Flüssigkeit oder Feuchtigkeit infolge einer Betauung oder dergleichen in das Leistungshalbleitermodul hinein, die zu Ausfällen des Leistungshalbleitermoduls führen können, auf konstruktiv einfache Weise verhindert wird.

Die Abkröpfung des jeweiligen Lastanschlusselementes bildet in vorteilhafter Weise eine mechanische Zugentlastung sowie ein Element zur Kompensation von temperaturbedingten Längenänderungen.

Vorteilhaft ist es bei dem erfindungsgemäßen Leistungshalbleitermodul, wenn die Dichtungsrippe eine Höhe besitzt, die größer ist als die Tiefe der zugehörigen Gehäusemulde. Desgleichen ist es bevorzugt, wenn die Dichtungsrippe eine Höhenabmessung besitzt, die größer ist als die Wanddicke der Kontakteinrichtung des jeweiligen Lastanschlusselementes. Durch eine solche Dimensionierung wird erreicht, dass Flüssigkeit bzw. kondensierende Feuchtigkeit nicht in das Innere des Gehäuses eindringen kann, sondern außenseitig abfließt.

Erfindungsgemäß ist es möglich, dass der umlaufende Dichtungsrahmen einfach aus dem Material des Gehäuses des Leistungshalbleitermoduls besteht, d.h. mit diesem einfach materialeinstückig z.B. durch Spritzgießen hergestellt ist. Bevorzugt kann es jedoch sein, wenn der Dichtungsrahmen oder zumindest die den Lastanschlusselementen zugeordneten Dichtungsrippen an ihrem Oberrand ein elastisches Dichtungselement aufweisen. Bei diesem Dichtungselement kann es sich um eine Dichtungsschnur handeln, die in eine im Dichtungsrahmen bzw. in der jeweiligen Dichtungsrippe ausgebildete Rille eingelegt oder eingeklebt ist. Desgleichen ist es möglich, dass das Dichtungselement mit dem Gehäuse des Leistungshalbleitermoduls in einem Zweikomponenten-Spritzgießverfahren direkt und unmittelbar herstellt wird.

Gute Dichtungseigenschaften gegen das Eindringen von Flüssigkeit oder Feuchtigkeit in das Innere des Leistungshalbleitermoduls ergeben sich, wenn der Deckel mit einem die Abkröpfung des jeweiligen Lastanschlusselementes übergreifenden Randabschnitt ausgebildet ist. Dieser Randabschnitt erstreckt sich selbstverständlich auch über die restlichen Abschnitte des umlaufenden Dichtungsrahmens des Gehäuses des erfindungsgemäßen Leistungshalbleitermoduls.

Erfindungsgemäß kann das Gehäuse für einen Teilmodul vorgesehen sein. Bevorzugt ist es jedoch, wenn das Gehäuse für eine Anzahl Teilmodule vorgesehen ist. Handelt es sich bei den Teilmodulen z.B. um sogenannte Halbbrücken, so ist erfindungsgemäß beispielsweise eine Dreiphasen-Vollbrücke mit einem gemeinsamen Gehäuse und einem dieses bedeckenden Deckel realisierbar.

Weitere Einzelheiten, Merkmale und Vorteile ergeben sich aus der nachfolgenden Beschreibung eines in der Zeichnung dargestellten Ausführungsbeispieles des erfindungsgemäßen Leistungshalbleitermoduls bzw. wesentlicher Einzelheiten desselben.

Es zeigen:
- Figur 1: teilweise aufgeschnitten eine perspektivische Ansicht einer Ausbildung des Leistungshalbleitermoduls,
- Figur 2: perspektivisch einen Abschnitt des Gehäuses des Leistungshalbleitermoduls,
- Figur 3: in einer perspektivischen Ansicht einen Abschnitt des Gehäuses, der Lastarischlusselemente sowie eines Substrates des Leistungshalbleitermoduls in einer Schnittdarstellung,
- Figur 4: abschnittweise in einer Schnittdarstellung Einzelheiten des Leistungshalbleitermoduls, d.h. seines Gehäuses, eines Lastanschlusselementes und des Deckels,
- Figur 5: eine der Figur ähnliche abschnittweise Schnittdarstellung einer anderen Ausbildung des Leistungshalbleitermoduls, und
- Figur 6: eine der Figur 5 ähnliche abschnittweise Schnittdarstellung noch einer anderen Ausführungsform des Leistungshalbleitermoduls.

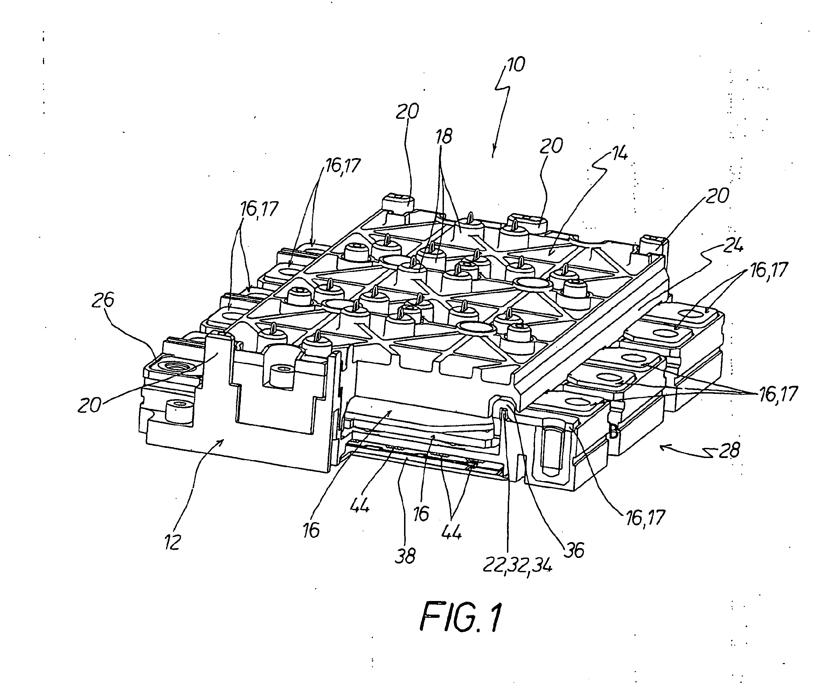

Figur 1 zeigt eine Ausbildung des Leistungshalbleitermoduls 10, der ein Gehäuse 12 und einen das Gehäuse 12 verschließenden Deckel 14 aufweist. Aus dem Gehäuse 12 stehen Lastanschlusselemente 16 mit ihren Kontakteinrichtungen 17 vor. Der Deckel 14 ist mit Erhebungen 18 für Hilfsanschlusselemente ausgebildet.

Vom Gehäuse 12 stehen Lageransätze 20 weg, an welchen eine (nicht gezeichnete) Schaltungsplatine befestigbar ist.

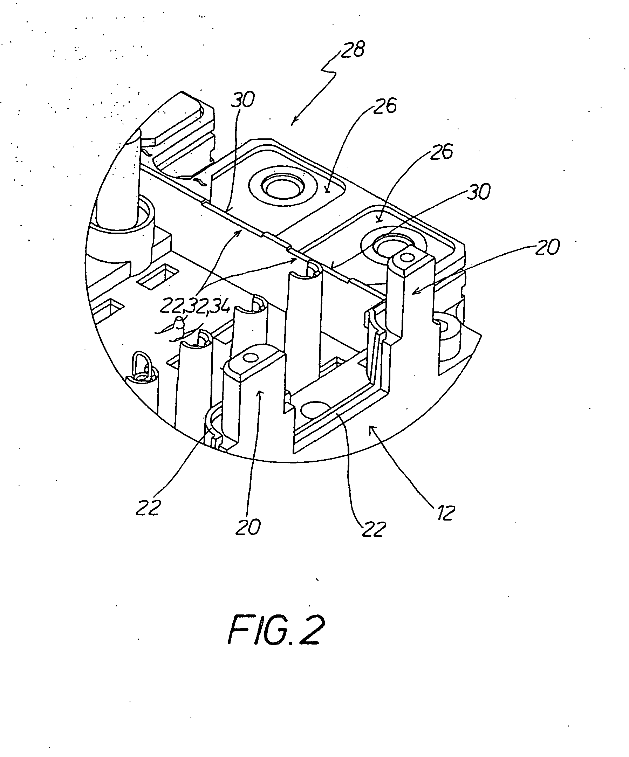

Wie aus Figur 2 ersichtlich ist, ist das Gehäuse 12 oberseitig materialeinstückig mit einen umlaufenden Dichtungsrahmen 22 ausgebildet, über welchen der Deckel 14 mit seinem Außenrand 24 übersteht.

Das Gehäuse 12 ist mit Gehäusemulden 26 (siehe Figur 2) ausgebildet, die für die Kontakteinrichtungen 17 der Lastanschlusselemente 16 (siehe Figur 1) vorgesehen sind. Die Gehäusemulden 26 sind an einer zugehörigen Seitenwand 28 des Gehäuses 12 ausgebildet. Die jeweilige Gehäusemulde 26 weist an ihrem Innenrand 30 eine einen Abschnitt 32 des Dichtungsrahmen 22 des Gehäuses 12 bildende Dichtungsrippe 34 auf.

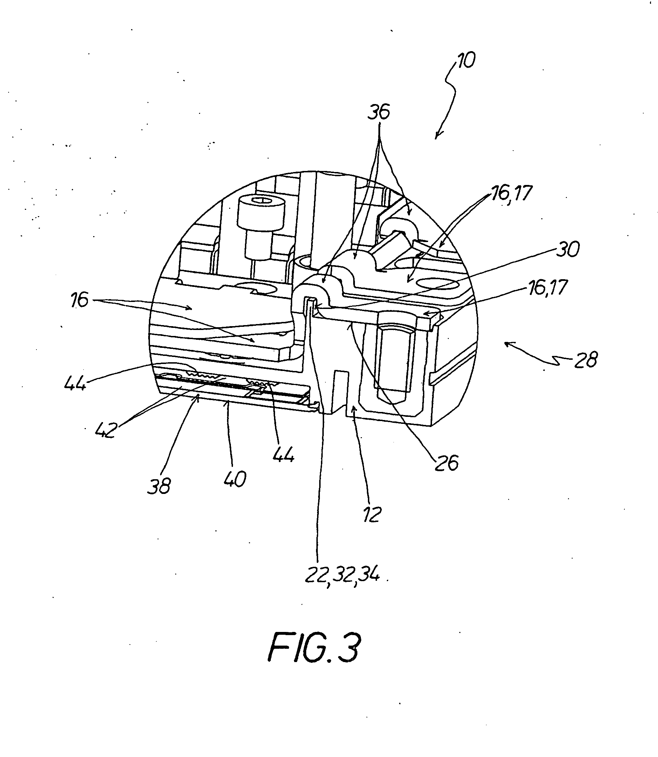

Wie aus Figur 3 ersichtlich ist, ist das jeweilige Lastanschlusselement 16 mit einer um die zugehörige Dichtungsrippe 34 herumgebogene Abkröpfung 36 ausgebildet, an welche die zugehörige Kontakteinrichtung 17 anschließt.

Mit der Bezugsziffer 38 ist in Figur 3 ein Substrat des Leistungshalbleitermoduls 10 bezeichnet, das an der Unterseite des Gehäuses 12 passend angebracht ist. Das Substrat 38 ist an seiner Unterseite mit einer flächigen Metallschicht 40 und an seiner Oberseite- d.h. Innenseite mit einer strukturierten Metallschicht 42 ausgebildet und mit Leistungselektronik-Bauelementen bestückt.

Die Lastanschlusselemente 16 sind in an sich bekannter Weise mit Kontaktfüßen 44 ausgebildet, die mit der strukturierten Metallschicht 42 des Substrates 38 kontaktiert sind.

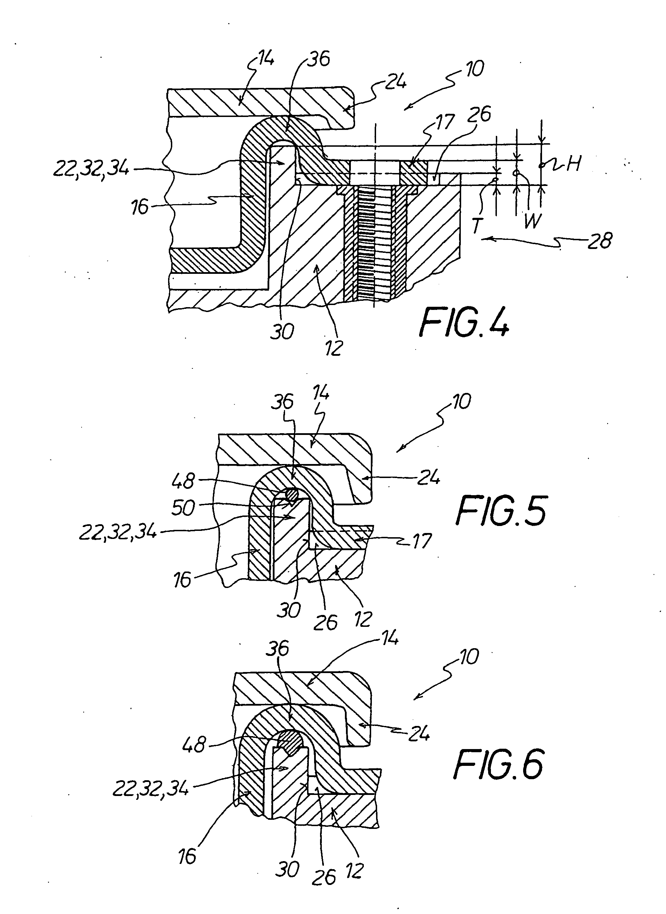

Wie aus Figur 4 ersichtlich ist, besitzt die jeweilige Dichtungsrippe 34 eine Höhe H, die größer ist als die Tiefe T der zugehörigen Gehäusemulde 26. Die Höhe H der jeweiligen Dichtungsrippe 34 ist auch größer als die Wanddicke W der zugehörigen Kontakteinrichtung 17 des entsprechenden Lastanschlusselementes. 16. Mit der Bezugsziffer 36 ist auch in Figur 4 die Abkröpfung des jeweiligen Lastanschlusselementes 16 und mit der Bezugsziffer 14 der Deckel des Leistungshalbleitermoduls 10 bezeichnet. Die Figur 4 verdeutlicht außerdem, dass der Deckel 14 mit seinem Außenrand 24 den umlaufenden Dichtungsrahmen 22 des Gehäuses 12 übergreift, so dass ein Eindringen von Flüssigkeit oder Feuchtigkeit in das Innere des Leistungshalbleitermoduls 10 verhindert wird.

Figur 5 zeigt in einer der Figur 4 ähnlichen abschnittweisen Schnittdarstellung eine Ausbildung des Leistungshalbleitermoduls 10, wobei der Dichtungsrahmen 22 des Gehäuses 12 bzw. zumindest die jeweilige Dichtungsrippe 34 an ihrem Oberrand 46 ein elastisches Dichtungselement 48 aufweist. Bei diesem elastischen Dichtungselement 48 kann es sich beispielsweise um eine Dichtungsschnur handeln, die in einer im Oberrand 46 ausgebildeten Rinne 50 angeordnet oder festgeklebt ist. Demgegenüber verdeutlicht die Figur 6 in einer der Figur 5 ähnlichen abschnittweisen Schnittdarstellung eine Ausbildung des Leistungshalbleitermoduls 10, wobei das elastische Dichtungselement 48 mit dem Gehäuse 12 direkt und unmittelbar gemeinsam durch Zweikomponenten-Spritzgießen realisiert ist.

Gleiche Einzelheiten sind in den Figuren jeweils mit denselben Bezugsziffern bezeichnet, so dass es sich erübrigt, in Verbindung mit allen Zeichnungsfiguren alle Einzelheiten jeweils detailliert zu beschreiben.

### Bezugsziffernliste:

- 10: Leistungshalbleitermodul
- 12: Gehäuse (von 10)
- 14: Deckel (von 10 für 12)
- 16: Lastanschlusselemente (von 10)
- 17: Kontakteinrichtungen (von 16 in 26)
- 18: Erhebungen (an 14)
- 20: Lageransätze (an 12)
- 22: Dichtungsrahmen (von 12)
- 24: Außenrand (von 14)
- 26: Gehäusemulden (von 12 für 17 an 28)
- 28: Seitenwand (von 12)
- 30: Innenrand (von 26)
- 32: Abschnitte (von 22 bei 26)
- 34: Dichtungsrippe (bei 32)
- 36: Abkröpfung (von 16)
- 38: Substrat (von 10)
- 40: Metallschicht (von 38)
- 42: strukturierte Metallschicht (von 38)
- 44: Kontaktfüße (von 16 für 42)
- 46: Oberrand (von 22 bzw. 34)
- 48: elastisches Dichtungselement (an 46 für 14)
- 50: Rinne (in 46 für 48)

## Patentansprüche

1. Leistungshalbleitermodul mit einem Gehäuse (12), in welchem Lastanschlusselemente (16) angeordnet sind, die Kontakteinrichtungen (17) aufweisen, die in Gehäusemulden (26) des Gehäuses (12) angeordnet sind, die an einer zugehörigen Seitenwand (28) des Gehäuses (12) ausgebildet sind, und mit einem das Gehäuse (12) bedeckenden Deckel (14),
**dadurch gekennzeichnet,**
**dass** das Gehäuse (12) oberseitig materialeinstückig mit einem umlaufenden Dichtungsrahmen (22) und der Deckel (14) mit einem den umlaufenden Dichtungsrahmen (22) übergreifenden Außenrand (24) ausgebildet ist und
**dadurch gekennzeichnet,**
**dass** die jeweilige Gehäusemulde (26) an ihrem Innenrand (30) eine einen Abschnitt des Dichtungsrahmens (22) bildende Dichtungsrippe (34) aufweist, und dass das zugehörige Lastanschlusselement (16) mit einer um die Dichtungsrippe (34) herumgebogene Abkröpfung (36) ausgebildet ist, an welche die zugehörige Kontakteinrichtung (17) anschließt.

2. Leistungshalbleitermodul nach Anspruch 1,
**dadurch gekennzeichnet,**
**dass** die Dichtungsrippe (34) eine Höhe (H) besitzt, die größer ist als die Tiefe (T) der zugehörigen Gehäusemulde (26).

3. Leistungshalbleitermodul nach Anspruch 1,
**dadurch gekennzeichnet,**
**dass** die Dichtungsrippe (34) eine Höhe (H) besitzt, die größer ist als die Wanddicke (W) der Kontakteinrichtung (17).

4. Leistungshalbleitermodul nach einem der Ansprüche 1 bis 3,
**dadurch gekennzeichnet,**
**dass** der Dichtungsrahmen (22) oder zumindest die Dichtungsrippen (34) an ihrem Oberrand (46) ein elastisches Dichtungselement (48) aufweisen.

5. Leistungshalbleitermodul nach einem der Ansprüche 1 bis 4,
**dadurch gekennzeichnet,**
**dass** der Deckel (14) mit einem die Abkröpfung (36) des jeweiligen Lastanschlusselementes (16) übergreifenden Randabschnitt (24) ausgebildet ist.

6. Leistungshalbleitermodul nach einem der Ansprüche 1 bis 5,
**dadurch gekennzeichnet,**
**dass** das Gehäuse (12) für eine Anzahl Substrate (38) und/oder Teilmodule vorgesehen ist.

## Claims

1. Power semiconductor module with a housing (12) in which load terminal elements (16) are arranged, which have contact devices (17) which are arranged in cavities (26) in the housing (12), which cavities are formed on an associated side wall (28) of the housing (12), and with a lid (14) which covers the housing (12),
**characterized in that**
the housing (12) is constructed to be materially integral with a peripheral sealing frame (22), and the lid (14) is constructed with an outer edge (24) which engages over the peripheral sealing frame (22), and
**characterized in that**
the respective housing cavity (26) has on its inner edge (30) a sealing rib (34) which forms a section of the sealing frame (22), and **in that** the associated load terminal element (16) is constructed with a bend (36) which is bent around the sealing rib (34), to which bend the associated contact device (17) is connected.

2. Power semiconductor module according to Claim 1,
**characterized in that**
the sealing rib (34) has a height (H) which is greater than the depth (T) of the associated housing cavity (26).

3. Power semiconductor module according to Claim 1,
**characterized in that**
the sealing rib (34) has a height (H) which is greater than the wall thickness (W) of the contact device (17).

4. Power semiconductor module according to one of Claims 1 to 3,
**characterized in that**
the sealing frame (22) or at least the sealing ribs (34) have on their upper edge (46) an elastic sealing element (48).

5. Power semiconductor module according to one of Claims 1 to 4,
**characterized in that**
the lid (14) is configured with an edge section (24) which engages over the bend (36) of the respective load terminal element (16).

6. Power semiconductor module according to one of Claims 1 to 5,
**characterized in that**
the housing (12) is provided for a number of substrates (38) and/or submodules.

## Revendications

1. Module à semi-conducteurs de puissance comprenant un boîtier (12), dans lequel des éléments de raccordement de charge (16) sont disposés, qui présentent des systèmes de contact (17) qui sont disposés dans des cavités (26) du boîtier (12), lesquelles sont réalisées sur une paroi latérale (28) spécifique du boîtier (12), et un couvercle (14) recouvrant le boîtier (12),
**caractérisé en ce que**
le boîtier (12) est réalisé sur le côté supérieur d'un seul tenant au niveau du matériau avec un cadre d'étanchéité (22) périphérique et le couvercle (14) avec un bord extérieur (24) recouvrant le cadre d'étanchéité (22) périphérique et **caractérisé en ce que**
la cavité de boîtier (26) respective présente sur son bord intérieur (30) une nervure d'étanchéité (34) formant une partie du cadre d'étanchéité (22) et **en ce que** l'élément de raccordement de charge (16) spécifique est réalisé avec un coudage (36) plié autour de la nervure d'étanchéité (34), coudage auquel le système de contact (17) spécifique se raccorde.

2. Module à semi-conducteurs de puissance selon la revendication 1,
**caractérisé en ce que**
la nervure d'étanchéité (34) présente une hauteur (H) qui est supérieure à la profondeur (T) de la cavité de boîtier (26) spécifique.

3. Module à semi-conducteurs de puissance selon la revendication 1,
**caractérisé en ce que**
la nervure d'étanchéité (34) présente une hauteur (H) qui est supérieure à l'épaisseur de paroi (W) du système de contact (17).

4. Module à semi-conducteurs de puissance selon l'une quelconque des revendications 1 à 3,
**caractérisé en ce que**
le cadre d'étanchéité (22) ou au moins les nervures d'étanchéité (34) présentent un élément d'étanchéité (48) élastique sur leur bord supérieur (46).

5. Module à semi-conducteurs de puissance selon l'une quelconque des revendications 1 à 4,
**caractérisé en ce que**
le couvercle (14) est réalisé avec une partie de bordure (24) recouvrant le coudage (36) de l'élément de raccordement de charge (16) concerné.

6. Module à semi-conducteurs de puissance selon l'une quelconque des revendications 1 à 5,
**caractérisé en ce que**
le boîtier (12) est prévu pour un certain nombre de substrats (38) et/ou de modules partiels.
